# EUROPEAN PATENT APPLICATION

(11) **EP 4 435 965 A1**
(43) Date of publication of application: **25.09.2024**
(21) Application number: 24718022.7
(22) Date of filing: 06.02.2024
(51) Int. Cl.: H01Q 1/02, H05K 7/20

(54) **ELECTRONIC DEVICE COMPRISING HEAT DISSIPATION MEMBER**

(30) Priority: 06.02.2023 KR 20230015412; 06.03.2023 KR 20230029380
(71) Applicant: Samsung Electronics Co., Ltd., Suwon-si, Gyeonggi-do 16677 (KR)
(72) Inventor: PARK, Woojin, Suwon-si, Gyeonggi-do 16677 (KR); LEE, Seunghwan, Suwon-si, Gyeonggi-do 16677 (KR); SEO, Junghoon, Suwon-si, Gyeonggi-do 16677 (KR); LEE, Hanyeop, Suwon-si, Gyeonggi-do 16677 (KR); LIM, Gun, Suwon-si, Gyeonggi-do 16677 (KR); CHOI, Jinchul, Suwon-si, Gyeonggi-do 16677 (KR)
(74) Representative: Gulde & Partner
(86) International application number: PCT/KR2024/001692
(87) International publication number: WO 2024/167258

(57) **Abstract**

An electronic device according to an embodiment of the disclosure may include a first heat dissipating plate that is made of a metallic material and includes a first antenna including a first opening extending in a first direction and a second opening extending in a second direction and connected to the first opening, a first printed circuit board disposed on the first heat dissipating plate and including a feeding part that overlaps with at least a part of the first opening and the second opening, is made of a metallic material, and is electrically connected to the communication module of the electronic device, and a heat dissipating fin made of a metallic material and disposed on the first heat dissipating plate in a direction perpendicular to the first direction and the second direction.

## Description

### [Technical Field]

Various embodiments disclosed herein relate to an electronic device including a heat sink.

### [Background Art]

In order to meet wireless data traffic demands increasing after commercialization of 4G communication systems, efforts to develop improved 5G communication systems or pre-5G communication systems have been made. For this reason, 5G communication systems or pre-5G communication systems are called beyond-4G network communication systems or post-LTE systems.

To achieve higher data transfer rates, 5G communication systems are being implemented in a super-high frequency (mmWave) band (e.g., 28 GHz or 39 GHz band).

Meanwhile, with the commencement of 5G services, additional service bands may be added. Accordingly, an electronic device includes a greater number of antenna radiators than before.

### [Disclosure of Invention]

### [Technical Problem]

A product that improves mobile network (e.g., 5G) communication speed and is simultaneously accessible by multiple electronic devices has an increased number of communication components, and thus consumes substantial current and power. Therefore, heat dissipation of communication components is becoming important. In order to accomplish heat dissipation of a communication component, a heat dissipating plate in contact with the communication component may be disposed in an electronic device.

The heat dissipating plate may be made of a metallic material so as to disperse heat. An antenna disposed in the electronic device may be spaced a predetermined distance apart from the heat dissipating plate made of a metallic material, so as to ensure the communication performance of the antenna. When the volume of the heat dissipating plate is enlarged within a limited volume of the electronic device to ensure the heat dissipating performance of the communication component, the distance between the heat dissipating plate and the antenna is not secured whereby the performance of the antenna may be degraded. On the contrary, if the volume of the heat dissipating plate is limited, smooth heat dissipation of the communication component fails and thus the performance thereof may be reduced. If the volume of the heat dissipating plate is enlarged and the distance between the heat dissipating plate and the antenna is secured so as to ensure both the heat dissipating performance of the communication component and the antenna performance, the electronic device may be enlarged.

According to an embodiment of the disclosure, an antenna is configured on a heat dissipating plate, whereby the volume of the heat dissipating plate is maximized within a limited volume of an electronic device, and antenna performance degradation may be prevented or reduced.

### [Solution to Problem]

An electronic device according to an embodiment of the disclosure may includes a communication module, a first heat dissipating plate that is made of a metallic material and includes a first antenna including a first opening extending in a first direction and a second opening extending in a second direction and connected to the first opening, a first printed circuit board disposed on the first heat dissipating plate and including a feeding part that overlaps with at least a part of the first opening and the second opening, is made of a metallic material, and is electrically connected to the communication module of the electronic device, and a heat dissipating fin made of a metallic material and disposed on the first heat dissipating plate in a direction perpendicular to the first direction and the second direction.

A heat sink disposed in an electronic device including a communication module (190) to transmit or receive a communication signal with an external electronic device according to an embodiment of the disclosure may include a heat dissipating plate that includes a first opening extending in a first direction and is made of a metallic material, a first printed circuit board disposed on the heat dissipating plate and including a feeding part that overlaps with at least a part of the first opening, is made of a metallic material, and is electrically connected to the communication module of the electronic device, and a heat dissipating fin disposed on the heat dissipating plate and made of a metallic material.

### [Advantageous Effects of Invention]

According to an embodiment disclosed herein, an antenna may be configured on a heat dissipating plate. An antenna is directly configured on a heat dissipating plate, whereby the distance between the antenna and the heat dissipating plate may not be necessary. Therefore, the volume of the heat dissipating plate is maximally secured within a limited internal space of an electronic device, so that the heat dissipating performance of the electronic device may be improved.

### [Brief Description of Drawings]

In relation to the description of drawings, the same or similar elements may be indicated by the same or similar reference signs.
FIG. 1 is a block diagram of an electronic device in a network environment according to various embodiments;
FIG. 2 is a block diagram of an electronic device for supporting legacy network communication and 5G network communication according to various embodiments;
FIG. 3A is a perspective view of an electronic device according to an embodiment of the disclosure;
FIG. 3B is an internal perspective view of an electronic device according to an embodiment of the disclosure;
FIG. 4A is an exploded perspective view of a heat sink according to an embodiment of the disclosure;
FIG. 4B and FIG. 4C are front perspective views of a heat sink according to an embodiment of the disclosure;
FIG. 4D is a view of the heat sink illustrated in FIG. 4A viewed in the -Y direction of FIG. 4A;
FIG. 5A is a diagram of a ground part and a feeding part of a first printed circuit board according to an embodiment of the disclosure;
FIG. 5B is a rear perspective view of a heat sink according to an embodiment of the disclosure;
FIG. 6A is a diagram illustrating a first antenna and a second antenna configured on a first heat dissipating plate according to an embodiment of the disclosure;
FIG. 6B is a diagram illustrating a structural relation between first heat dissipating fins, and a first opening and a second opening according to an embodiment of the disclosure;
FIG. 6C is a diagram illustrating a relation between first heat dissipating fins and the antenna performance of a first opening and a second opening;
FIG. 7A is a diagram illustrating a relation between a first opening of a first heat dissipating plate and a first feeding part according to an embodiment of the disclosure;
FIG. 7B is a diagram illustrating a relation between a second opening of a first heat dissipating plate and a second feeding part according to an embodiment of the disclosure;
FIG. 8A is a diagram illustrating an input reflection coefficient of a first antenna of a first heat dissipating plate;
FIG. 8B is a diagram illustrating an input reflection coefficient of a second antenna of a first heat dissipating plate;
FIG. 8C is a diagram illustrating isolation between a first antenna and a second antenna of a first heat dissipating plate;
FIG. 8D is a diagram illustrating the antenna gain of a first antenna and a second antenna of a first heat dissipating plate;
FIG. 8E is a diagram illustrating the antenna efficiency of a first antenna and a second antenna of a first heat dissipating plate;
FIG. 9 is a diagram of a heat sink according to an embodiment;
FIG. 10A and FIG. 10B are diagrams of the first heat dissipating plate of the heat sink illustrated in FIG. 9; and
FIG. 11 is a diagram illustrating an antenna input reflection coefficient for a first opening disposed through the first heat dissipating plate of FIG. 9.

### [Mode for the Invention]

It should be appreciated that various embodiments of the present disclosure and the terms used therein are not intended to limit the technological features set forth herein to particular embodiments and include various changes, equivalents, or replacements for a corresponding embodiment.

With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1 st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

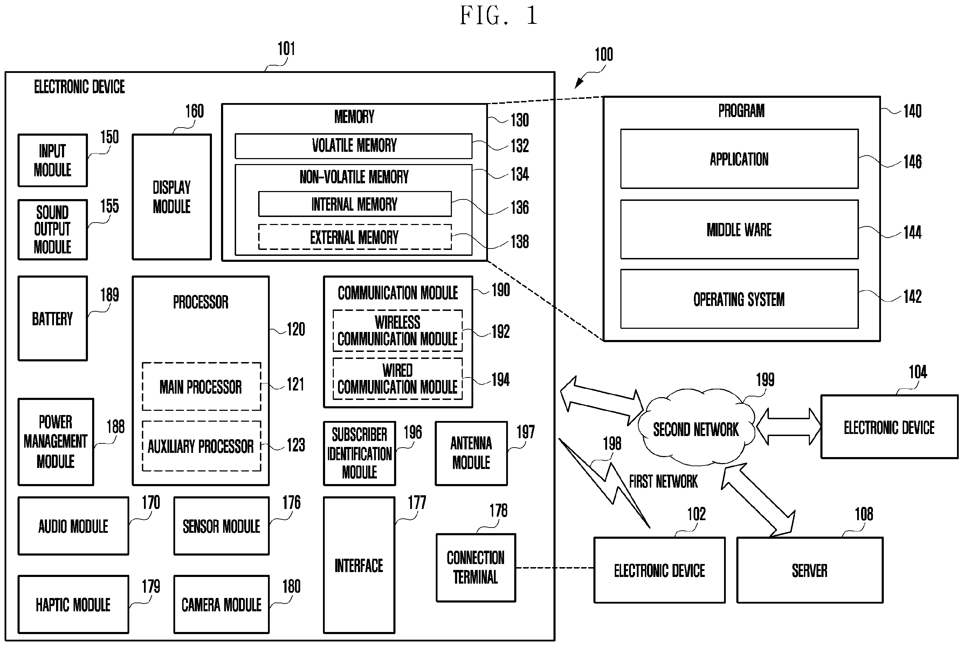

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

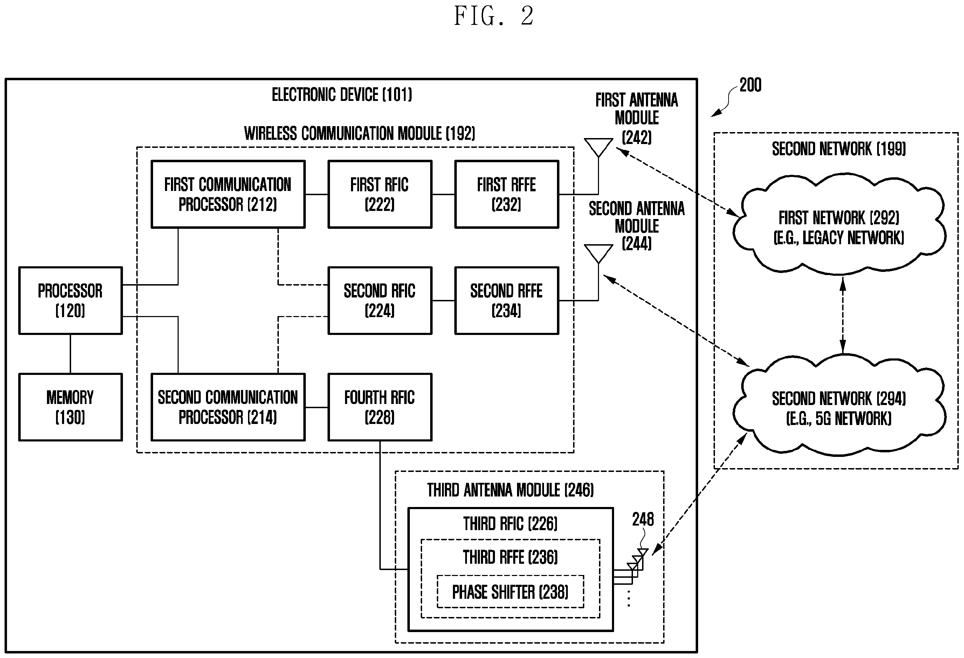

FIG. 2 is a block diagram illustrating an electronic device in a network environment including a plurality of cellular networks according to various embodiments of the disclosure.

Referring to FIG. 2, the electronic device 101 may include a first communication processor 212, second communication processor 214, first RFIC 222, second RFIC 224, third RFIC 226, fourth RFIC 228, first radio frequency front end (RFFE) 232, second RFFE 234, first antenna module 242, second antenna module 244, and antenna 248. The electronic device 101 may include a processor 120 and a memory 130. A second network 199 may include a first cellular network 292 and a second cellular network 294. According to another embodiment, the electronic device 101 may further include at least one of the components described with reference to FIG. 1, and the second network 199 may further include at least one other network. According to one embodiment, the first communication processor 212, second communication processor 214, first RFIC 222, second RFIC 224, fourth RFIC 228, first RFFE 232, and second RFFE 234 may form at least part of the wireless communication module 192. According to another embodiment, the fourth RFIC 228 may be omitted or included as part of the third RFIC 226.

The first communication processor 212 may establish a communication channel of a band to be used for wireless communication with the first cellular network 292 and support legacy network communication through the established communication channel. According to various embodiments, the first cellular network may be a legacy network including a second generation (2G), 3G, 4G, or long term evolution (LTE) network. The second communication processor 214 may establish a communication channel corresponding to a designated band (e.g., about 6 GHz to about 60 GHz) of bands to be used for wireless communication with the second cellular network 294, and support 5G network communication through the established communication channel. According to various embodiments, the second cellular network 294 may be a 5G network defined in 3GPP. Additionally, according to an embodiment, the first communication processor 212 or the second communication processor 214 may establish a communication channel corresponding to another designated band (e.g., about 6 GHz or less) of bands to be used for wireless communication with the second cellular network 294 and support 5G network communication through the established communication channel. According to one embodiment, the first communication processor 212 and the second communication processor 214 may be implemented in a single chip or a single package. According to various embodiments, the first communication processor 212 or the second communication processor 214 may be formed in a single chip or a single package with the processor 120, the auxiliary processor 123, or the communication module 190.

Upon transmission, the first RFIC 222 may convert a baseband signal generated by the first communication processor 212 to a radio frequency (RF) signal of about 700 MHz to about 3 GHz used in the first cellular network 292 (e.g., legacy network). Upon reception, an RF signal may be obtained from the first cellular network 292 (e.g., legacy network) through an antenna (e.g., the first antenna module 242) and be preprocessed through an RFFE (e.g., the first RFFE 232). The first RFIC 222 may convert the preprocessed RF signal to a baseband signal so as to be processed by the first communication processor 212.

Upon transmission, the second RFIC 224 may convert a baseband signal generated by the first communication processor 212 or the second communication processor 214 to an RF signal (hereinafter, 5G Sub6 RF signal) of a Sub6 band (e.g., 6 GHz or less) to be used in the second cellular network 294 (e.g., 5G network). Upon reception, a 5G Sub6 RF signal may be obtained from the second cellular network 294 (e.g., 5G network) through an antenna (e.g., the second antenna module 244) and be pretreated through an RFFE (e.g., the second RFFE 234). The second RFIC 224 may convert the preprocessed 5G Sub6 RF signal to a baseband signal so as to be processed by a corresponding communication processor of the first communication processor 212 or the second communication processor 214.

The third RFIC 226 may convert a baseband signal generated by the second communication processor 214 to an RF signal (hereinafter, 5G Above6 RF signal) of a 5G Above6 band (e.g., about 6 GHz to about 60 GHz) to be used in the second cellular network 294 (e.g., 5G network). Upon reception, a 5G Above6 RF signal may be obtained from the second cellular network 294 (e.g., 5G network) through an antenna (e.g., the antenna 248) and be preprocessed through the third RFFE 236. The third RFIC 226 may convert the preprocessed 5G Above6 RF signal to a baseband signal so as to be processed by the second communication processor 214. According to one embodiment, the third RFFE 236 may be formed as part of the third RFIC 226.

According to an embodiment, the electronic device 101 may include a fourth RFIC 228 separately from the third RFIC 226 or as at least part of the third RFIC 226. In this case, the fourth RFIC 228 may convert a baseband signal generated by the second communication processor 214 to an RF signal (hereinafter, an intermediate frequency (IF) signal) of an intermediate frequency band (e.g., about 9 GHz to about 11 GHz) and transfer the IF signal to the third RFIC 226. The third RFIC 226 may convert the IF signal to a 5G Above 6RF signal. Upon reception, the 5G Above 6RF signal may be received from the second cellular network 294 (e.g., a 5G network) through an antenna (e.g., the antenna 248) and be converted to an IF signal by the third RFIC 226. The fourth RFIC 228 may convert an IF signal to a baseband signal so as to be processed by the second communication processor 214.

According to one embodiment, the first RFIC 222 and the second RFIC 224 may be implemented into at least part of a single package or a single chip. According to one embodiment, the first RFFE 232 and the second RFFE 234 may be implemented into at least part of a single package or a single chip. According to one embodiment, at least one of the first antenna module 242 or the second antenna module 244 may be omitted or may be combined with another antenna module to process RF signals of a corresponding plurality of bands.

According to one embodiment, the third RFIC 226 and the antenna 248 may be disposed at the same substrate to form a third antenna module 246. For example, the wireless communication module 192 or the processor 120 may be disposed at a first substrate (e.g., main PCB). In this case, the third RFIC 226 is disposed in a partial area (e.g., lower surface) of the first substrate and a separate second substrate (e.g., sub PCB), and the antenna 248 is disposed in another partial area (e.g., upper surface) thereof; thus, the third antenna module 246 may be formed. By disposing the third RFIC 226 and the antenna 248 in the same substrate, a length of a transmission line therebetween can be reduced. This may reduce, for example, a loss (e.g., attenuation) of a signal of a high frequency band (e.g., about 6 GHz to about 60 GHz) to be used in 5G network communication by a transmission line. Therefore, the electronic device 101 may improve a quality or speed of communication with the second cellular network 294 (e.g., 5G network).

According to one embodiment, the antenna 248 may be formed in an antenna array including a plurality of antenna elements that may be used for beamforming. In this case, the third RFIC 226 may include a plurality of phase shifters 238 corresponding to a plurality of antenna elements, for example, as part of the third RFFE 236. Upon transmission, each of the plurality of phase shifters 238 may convert a phase of a 5G Above6 RF signal to be transmitted to the outside (e.g., a base station of a 5G network) of the electronic device 101 through a corresponding antenna element. Upon reception, each of the plurality of phase shifters 238 may convert a phase of the 5G Above6 RF signal received from the outside to the same phase or substantially the same phase through a corresponding antenna element. This enables transmission or reception through beamforming between the electronic device 101 and the outside.

The second cellular network 294 (e.g., 5G network) may operate (e.g., stand-alone (SA)) independently of the first cellular network 292 (e.g., legacy network) or may be operated (e.g., non-stand alone (NSA)) in connection with the first cellular network 292. For example, the 5G network may have only an access network (e.g., 5G radio access network (RAN) or a next generation (NG) RAN and have no core network (e.g., next generation core (NGC)). In this case, after accessing to the access network of the 5G network, the electronic device 101 may access to an external network (e.g., Internet) under the control of a core network (e.g., an evolved packed core (EPC)) of the legacy network. Protocol information (e.g., LTE protocol information) for communication with a legacy network or protocol information (e.g., new radio (NR) protocol information) for communication with a 5G network may be stored in the memory 130 to be accessed by other components (e.g., the processor 120, the first communication processor 212, or the second communication processor 214).

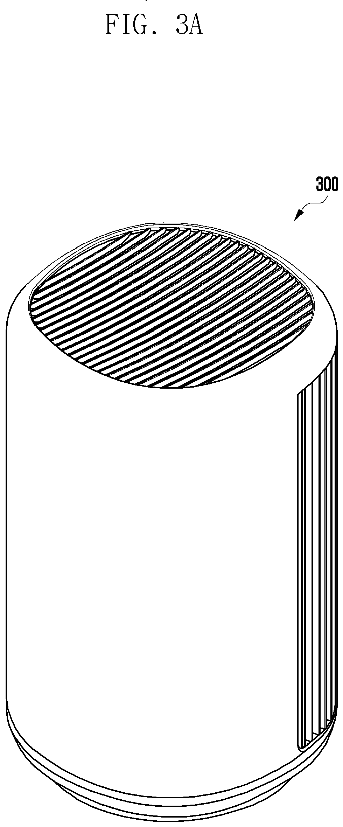

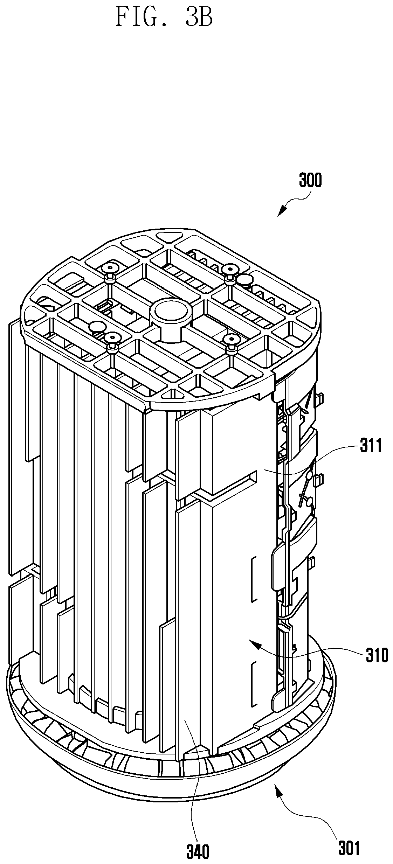

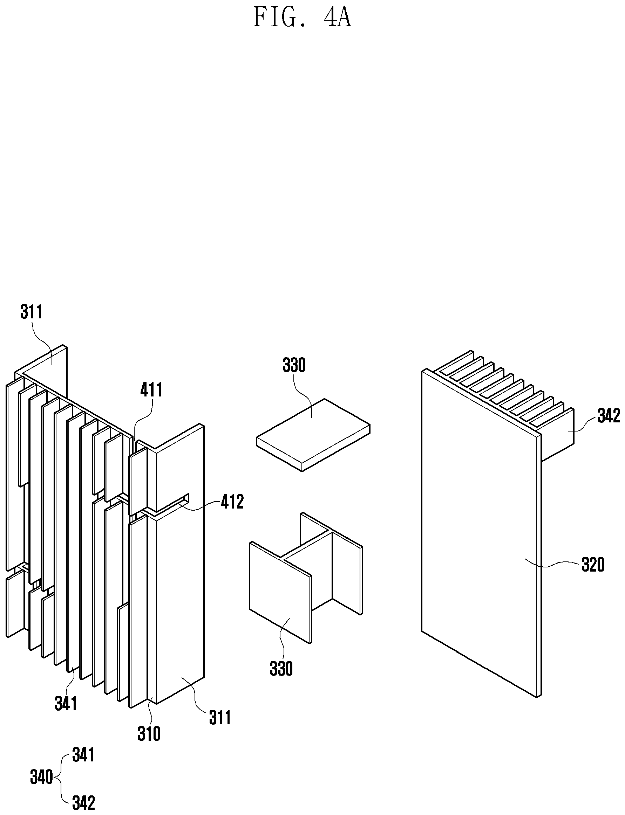

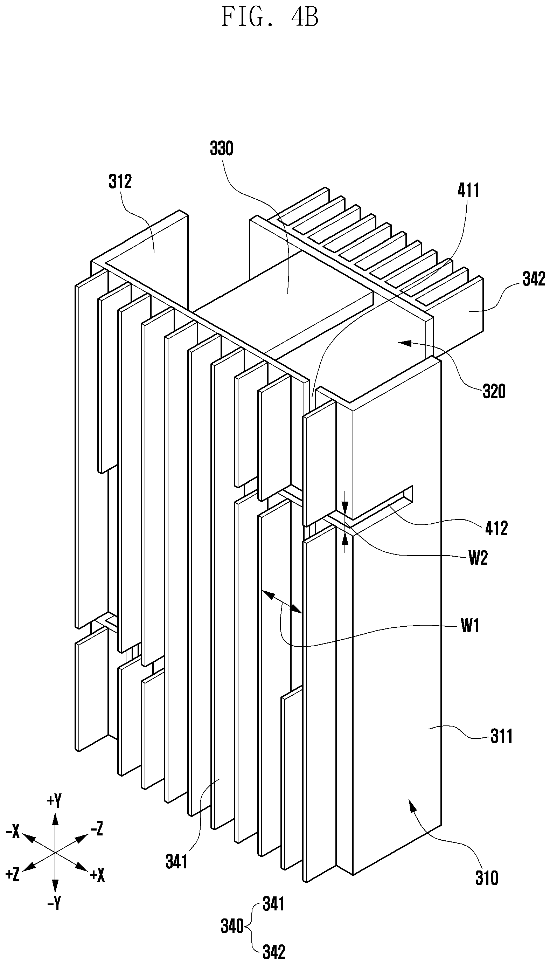

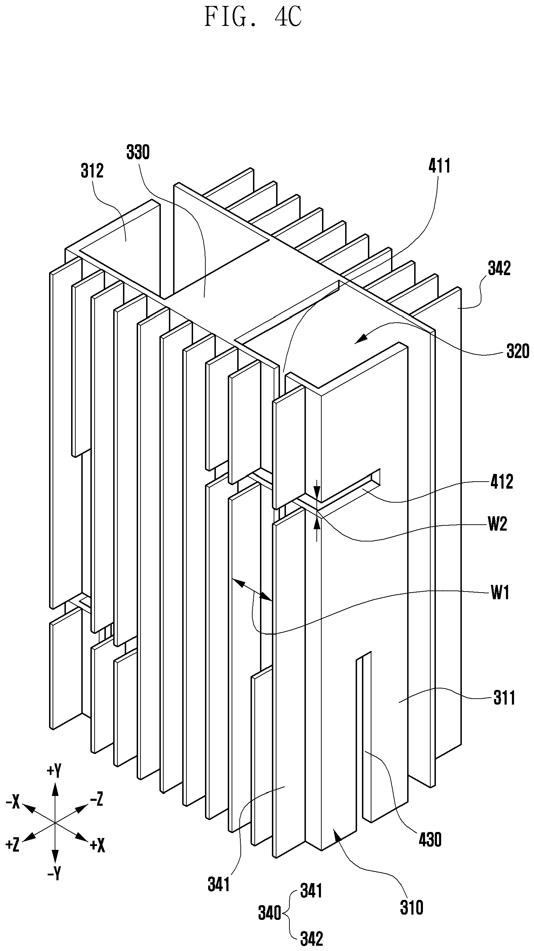

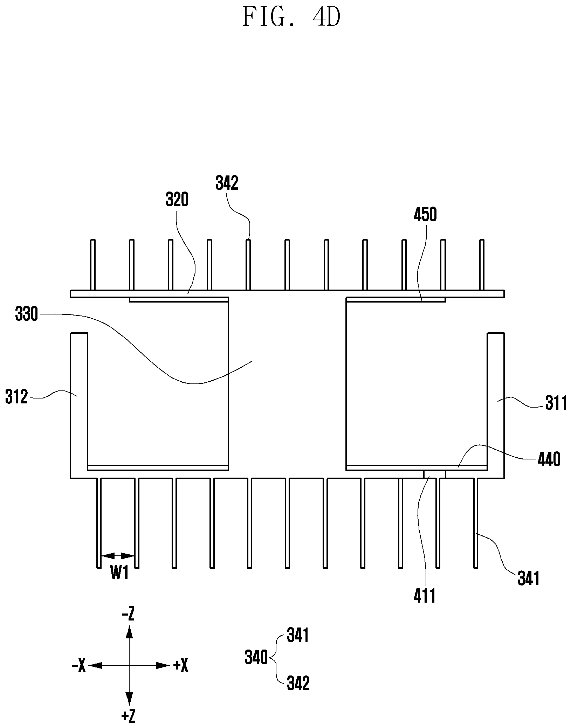

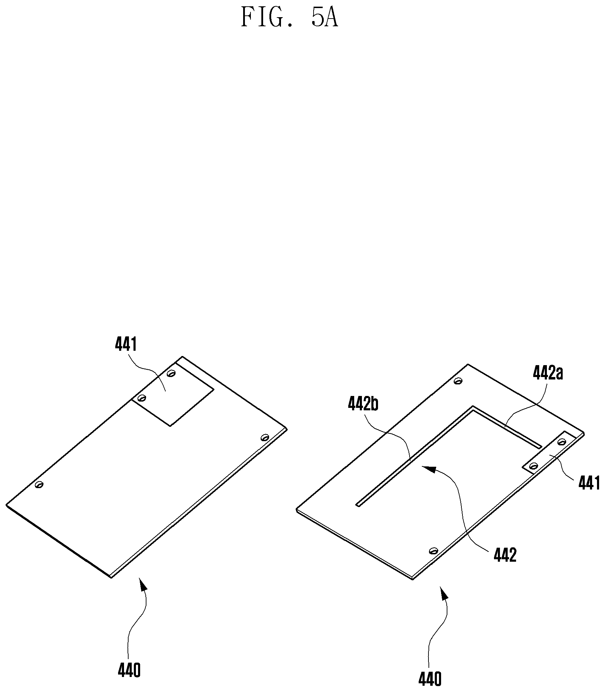

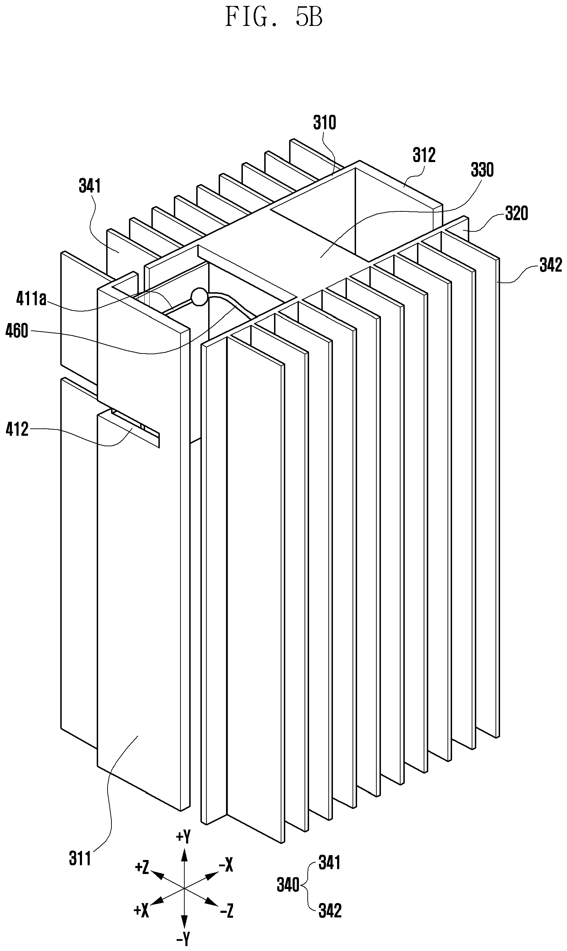

FIG. 3A is a perspective view of an electronic device 300 according to an embodiment of the disclosure. FIG. 3B is an internal perspective view of the electronic device 300 according to an embodiment of the disclosure. FIG. 4A is an exploded perspective view of a heat sink according to an embodiment of the disclosure. FIG. 4B and FIG. 4C are front perspective views of a heat sink according to an embodiment of the disclosure. FIG. 4D is a view of the heat sink illustrated in FIG. 4A viewed in the -Y direction of FIG. 4A. FIG. 5A is a diagram of a ground part and a feeding part of a first printed circuit board 440 according to an embodiment of the disclosure. FIG. 5B is a rear perspective view of a heat sink according to an embodiment of the disclosure.

According to an embodiment of the disclosure, as illustrated in FIG. 3A, the electronic device 300 may be an in-home relay device. The in-home relay device may refer a device that enables the seamless delivery of, to a home or office, high-speed Internet services using 5G communication provided by an Internet service provider (hereinafter, referred to as a "telecommunications company"). The in-home relay device may mean, for example, customer premises equipment (CPE). For example, the in-home relay device may be a broadband router. The in-home relay device may receive a 5G communication signal transmitted by a repeater installed by an Internet service provider, and is connected to the electronic device 300 in a home or office via various wireless protocols so as to enable a high-speed Internet service to be used in the electronic device 300. The various wireless protocols may include a short-range wireless communication protocol such as Wi-Fi and Bluetooth. Furthermore, the electronic device 300 may include the electronic device 300 that exchanges a communication signal with an external electronic device, like a notebook PC or a tablet PC.

According to an embodiment, the electronic device 300 may include an antenna. The antenna may receive radio waves provided from a repeater of a telecommunications company, or transmit radio waves. In an embodiment, the antenna may be an mmWave antenna. The antenna may transmit or receive a signal in a designated high frequency band (e.g., mmWave band). In an embodiment, the antenna may include a near field communication (NFC) antenna, a wireless charging antenna, a magnetic secure transmission (MST) antenna, and/or a high frequency (e.g., Wi-Fi, LTE, or mmWave) antenna. In addition, the antenna may wirelessly transmit or receive communication with an external electronic device in various bandwidths.

According to an embodiment, the antenna of the electronic device 300 may operate while being connected to the communication module 190. Referring to FIG. 4A described later, an antenna according to an embodiment of the disclosure may be configured on a first heat dissipating plate 310. The antenna and the first heat dissipating plate may be a single element, e.g. a single body made of a metallic material. The antenna configured on the first heat dissipating plate 310 may be electrically connected to the communication module 190 disposed on a second heat dissipating plate 320 and receive or transmit radio waves.

According to an embodiment, a communication component (e.g., the communication module 190) may generate heat during operation. For example, the communication component may generate heat by processing a large amount of data via 5G communication. When the communication component generates heat, the performance of the communication component may be degraded. In order to solve the performance degradation, the electronic device 300 may include a heat sink that disperses heat generated by an electronic component to the surroundings.

According to an embodiment, FIG. 3B is an internal diagram of the electronic device 300. The electronic device 300 may include a heat sink disposed on a body 301. In an embodiment, the heat sink may be in contact with an electronic component, such as the communication module 190 or a printed circuit board (e.g., the first printed circuit board 440 and/or a second printed circuit board 450) of the electronic device 300, and disperse heat generated by the electronic component to the surroundings. Therefore, performance degradation caused by heat generation of the electronic component may be alleviated.

According to an embodiment, as illustrated in FIG. 4A, FIG. 4B, FIG. 4C, and FIG. 4D, the heat sink may include the first heat dissipating plate 310, the second heat dissipating plate 320, a connection part 330, and/or heat dissipating fins 340. The heat sink may omit at least one element among the above elements, or add other elements. In an embodiment, the first heat dissipating plate 310, the second heat dissipating plate 320, the connection part 330, and/or the heat dissipating fins 340 may be made of a metallic material having a high thermal conductivity. In an embodiment, referring to FIG. 4D, the first printed circuit board 440 may be disposed on the first heat dissipating plate 310. More specifically, the first printed circuit board 440 may be disposed on an inner surface of the first heat dissipating plate 310, e.g. a surface of the first heat dissipating plate 310 facing the second heat dissipating plate 320. Heat generated by the first printed circuit board 440 may be dispersed to the surroundings through the first heat dissipating plate 310. In an embodiment, the second heat dissipating plate 320 may be disposed to face the first heat dissipating plate 310. In an embodiment, the second printed circuit board 450 including the communication module 190 electrically connected to the first printed circuit board 440 may be disposed on the second heat dissipating plate 320. More specifically, the second printed circuit board 450 may be disposed on an inner surface of the second heat dissipating plate 320, e.g. a surface of the second heat dissipating plate 320 facing the first heat dissipating plate 310. In an embodiment, the connection part 330 may be in contact with the first heat dissipating plate 310 and the second heat dissipating plate 320 so as to enlarge a heat dissipating area. In an embodiment, the heat dissipating fins 340 may include first heat dissipating fins 341 and second heat dissipating fins 342. The first heat dissipating fins 341 may be arranged to be perpendicular (e.g., a +Z direction based on FIG. 4B) to the first heat dissipating plate 310, so as to enlarge a heat dissipating area of the first heat dissipating plate 310. The first heat dissipating fins 341 may be connected to the first heat dissipating plate 310. More specifically, the first heat dissipating fins 341 may be connected to an outer surface of the first heat dissipating plate 310, e.g. a surface of the first heat dissipating place facing away from the second heat dissipating plate 320. In an embodiment, the second heat dissipating fins 342 may be arranged to be perpendicular (e.g., a -Z direction based on FIG. 4B) to the second heat dissipating plate 320, so as to enlarge a heat dissipating area of the second heat dissipating plate 320. The second heat dissipating fins 342 may be connected to the second heat dissipating plate 320. More specifically, the second heat dissipating fins 342 may be connected to an outer surface of the second heat dissipating plate 320, e.g. a surface of the second heat dissipating place facing away from the first heat dissipating plate 310. Therefore, heat generated by the first printed circuit board 440 and/or the second printed circuit board 450 may be diffused to the surroundings through the first heat dissipating plate 310, the second heat dissipating plate 320, the connection part 330, and/or the heat dissipating fins 340.

According to an embodiment not illustrated in the drawings, the antenna and the first heat dissipating plate 310 may be separately arranged. If there is a structure made of a metallic material at a position adjacent to the antenna, the performance of transmitting or receiving a signal in a designated frequency band (e.g., high frequency band) by the antenna may be degraded. In order to prevent or reduce such a phenomenon, the antenna may be positioned to be spaced apart from the first heat dissipating plate 310 made of a metallic material, so as to ensure the communication performance of the antenna. In this case, the electronic device 300 may be limited to secure a distance between the antenna and the first heat dissipating plate 310 within a limited volume. In addition, when the size of the first heat dissipating plate 310 is reduced to secure the distance between the first heat dissipating plate 310 and the antenna, smooth heat dissipation of a communication component (e.g., the communication module 190) may not be accomplished. Therefore, heat generation may decrease the performance of the communication module 190. According to an embodiment of the disclosure, as illustrated in FIG. 4A, FIG. 4B, and FIG. 4C, the antenna is configured on the first heat dissipating plate 310, whereby the volume of the heat dissipating plate 310 is maximally secured within a limited volume of the electronic device 300, and antenna performance degradation may be prevented or reduced. Hereinafter, a detailed description will be provided.

According to an embodiment, as illustrated in FIG. 4A, FIG. 4B, FIG. 4C, and FIG. 4D, the first heat dissipating plate 310 may be made of a conductive material and transmit or receive a communication signal with an external electronic device. The first heat dissipating plate 310 may be electrically connected to the communication module 190 included in the electronic device 300 and be used as an antenna operating in at least one band. The first heat dissipating plate 310 therefore may assume and combine multiple functions, i.e. the function of a heat dissipating device and the function of an antenna.

In an embodiment, referring to FIG. 4A, FIG. 4B, and FIG. 4C, an antenna may be integrated with the first heat dissipating plate 310. In an embodiment, the electronic device may include a first antenna and a second antenna. Each of the first antenna and the second antenna may include a slit and/or slot antenna having various lengths to transmit and/or receive a communication signal with an external electronic device in multiple bands. For example, an antenna including multiple openings, e.g. slits or slots, may be configured on the first heat dissipating plate 310. In an embodiment, the first antenna may include a first opening 411 extending on the first heat dissipating plate 310 in a first direction (e.g., a Y-axis direction based on FIG. 4B). The first opening 411 can be designed as a through opening, a hole, a slot or the like in the body of the heat dissipating plate 310. In addition, the first antenna may include a second opening 412 extending on the first heat dissipating plate 310 in a second direction (e.g., a X-axis direction based on FIG. 4B) and being connected to the first opening 411. Again, the second opening 412 can be designed as a through opening, a hole, a slot or the like in the body of the heat dissipating plate 310. In an embodiment, the first opening 411 and the second opening 412 may be connected orthogonally. For example, the first direction that is an extension direction of the first opening 411 and the second direction that is an extension direction of the second opening 412 may be perpendicular to each other. In an embodiment, the second antenna may have substantially the same structure as the first antenna. For example, the second antenna may include a third opening 421 extending on the first heat dissipating plate 310 in the first direction. In addition, the second antenna may include a fourth opening 422 extending on the first heat dissipating plate 310 in the second direction and being connected to the third opening 421. The third opening 421 and the fourth opening 422 may be connected orthogonally. An intersecting relation between the first opening 411 and the second opening 412 and/or an intersecting relation between the third opening 421 and the fourth opening 422 described above merely correspond to an example. Furthermore, the first opening 411, the second opening 412, the third opening 421, and the fourth opening 422 may intersect with each other at various angles.

In an embodiment, the first opening 411 and the second opening 412 may have at least one shape among a slit and/or slot. A slot antenna may be an opening surrounded by one surface of the first heat dissipating plate 310. A slit antenna may be an opening, at least a part of which is open. In other words, the slot and the slit may be openings, respectively, that connect two sides of the first heat dissipating plate 310, for example the two surfaces with the largest surface area. A slot may be limited by four side surfaces. A slit may be limited by three side surfaces and may be open in the direction of a fourth side. The following description will be provided under a precondition that the first opening 411, the second opening 412, the third opening 421, the fourth opening 422, and a fifth opening 430 (e.g., the fifth opening 430 in FIG. 4C) described later, described in the disclosure are slit antennas, slot antennas or a combination of slit antennas and slot antennas.

According to an embodiment, as illustrated in FIG. 5A, the first printed circuit board 440 may include a ground part (ground) 441 disposed on a first surface facing the first heat dissipating plate 310, and a feeding part (feeding line) 442 made of a conductive material and disposed on a second surface opposite to the first surface. In an embodiment, the ground part 441 may be a part to which charges accumulated around the first printed circuit board 440 are induced. The accumulated charges may move to the first heat dissipating plate 310 through the ground part 441 and thus not be discharged to an electronic component.

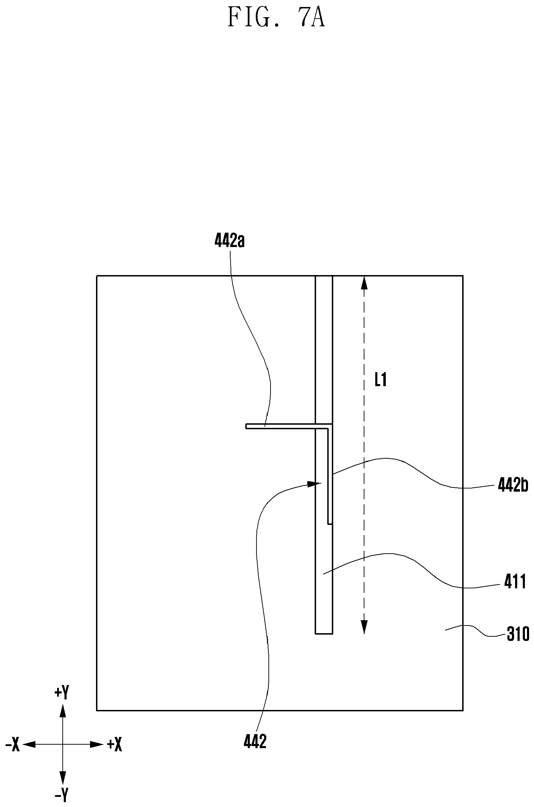

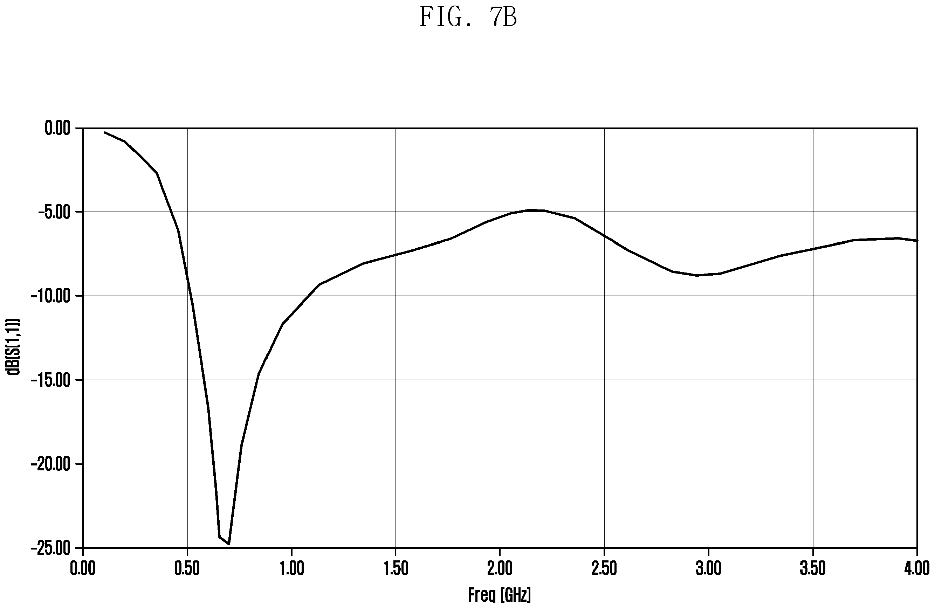

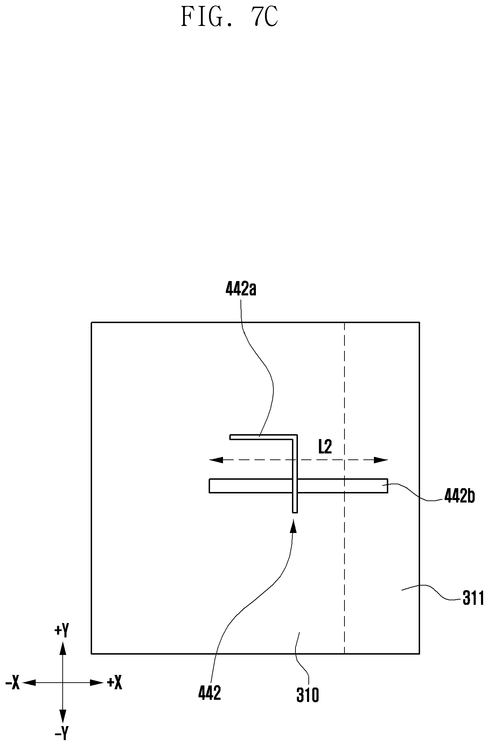

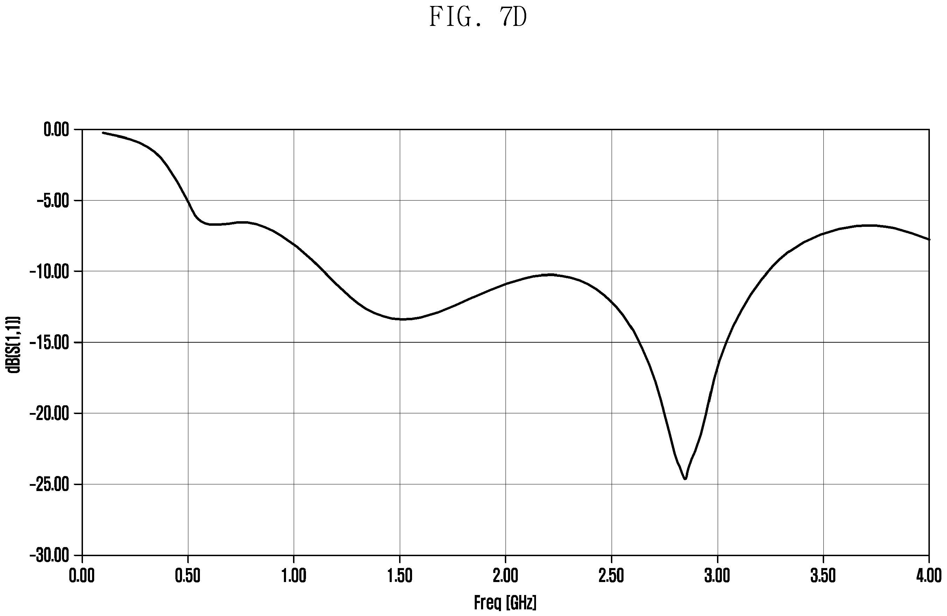

In an embodiment, the first heat dissipating plate 310 may transmit a communication signal through the feeding part 442 configured on the first printed circuit board 440. For example, the feeding part 442 may be a micro strip. In addition, the feeding part 442 may be implemented to have an impedance of 50 Ohm. In an embodiment, at least a part of the first opening 411 and the second opening 412 disposed through the first heat dissipating plate 310 may overlap with the feeding part 442. The feeding part 442 may include a first feeding part 442a and a second feeding part 442b. The first feeding part 442a and the second feeding part 442b may be integrated with each other. The first feeding part 442a may extend along a first direction and the second feeding part 442b may extend along a second direction. The first direction may be different from the second direction. The first direction and the second direction may form an angle, for example, a right angle. As illustrated in FIG. 7A and FIG. 7B described later, the first feeding part 442a of the feeding part 442 may cross over the first opening 411, and the second feeding part 442b may cross over the second opening 412. The first antenna may transmit or receive a communication signal in a particular frequency band with an external electronic device through the one feeding part 442. In this case, the number of radio frequency (RF) ports and a wiring space for the feeding part 442 may be reduced compared to multiple feeding parts 442 being arranged on the first opening 411 and the second opening 412 of the first antenna. Although not illustrated in the drawing, the second antenna may cross over the third opening 421 and the fourth opening 422, and transmit or receive a communication signal in a particular frequency band with an external electronic device through one feeding part (not illustrated) different from the feeding part 442 of the first antenna.

In an embodiment, as illustrated in FIG. 5B, the feeding part 442 of the first printed circuit board 440 may be electrically connected to the communication module 190 or 192 disposed on the second printed circuit board 450, through an RF connection member 460. The RF connection member 460 may transfer, to the feeding part 442, an RF signal processed in the communication module 190 of the electronic device 300, or transfer, to the communication module 190, an RF signal received from an external electronic device. In an embodiment, the RF connection member 460 may be a coaxial cable having an impedance of 50 Ohm.

According to an embodiment, the RF connection member 460 may include multiple circuit units. For example, the RF connection member 460 may include various antenna-related circuits, such as a matching circuit for impedance matching and a switching circuit for adapting an antenna to broadband characteristics. In an embodiment, the matching circuit may be a circuit including an element, such as an inductor or a capacitor, to matching impedance. In an embodiment, the switching circuit may short-circuit antenna radiators (e.g., the first opening 411 and/or the second opening 412 of the first heat dissipating plate 310), which are electrically open to each other, thereby increasing the physical length of the antenna radiators. The matching circuit and the switching circuit of the circuit units described above are not interpreted as limited by their names, and should be understood as circuits including an element capable of performing a corresponding function. For example, the switching circuit may be called a switching circuit unit, and the matching circuit may be called a variable element unit. In an embodiment, a part of the matching circuit or the switching circuit among antenna-related circuits may be omitted.

According to an embodiment, the second printed circuit board 450 may include various communication components. In an embodiment, an RFIC (e.g., indicated by reference numeral 226 in FIG. 2) may be disposed on the second printed circuit board 450. The RFIC may be configured to process a signal (RF signal or communication signal) in a selected frequency band (e.g., a frequency band having a range of 700 MHz-100 GHz), which is transmitted/received through the first heat dissipating plate 310. According to an embodiment, the RFIC may, at the time of transmission, convert a baseband signal obtained from a communication processor (not illustrated) into an RF signal in a designated band. The RFIC may convert an RF signal received from an external electronic device, into a baseband signal, and transfer same to the communication processor. According to an embodiment, the RFIC may, at the time of transmission, up-convert an IF signal (e.g., about 9 GHz-11 GHz) obtained from an intermediate frequency integrated circuit (IFIC) (e.g., indicated by reference numeral 228 in FIG. 2), into an RF signal in a selected band. The RFIC may, at the time of reception, down-convert an RF signal obtained from an external electronic device, into an IF signal, and transfer same to the IFIC.

In an embodiment, a PMIC 732 may be disposed on the second printed circuit board 450. The PMIC 732 may be supplied with voltage from the second printed circuit board 450 and provide required power to various components (e.g., the RFIC 452).

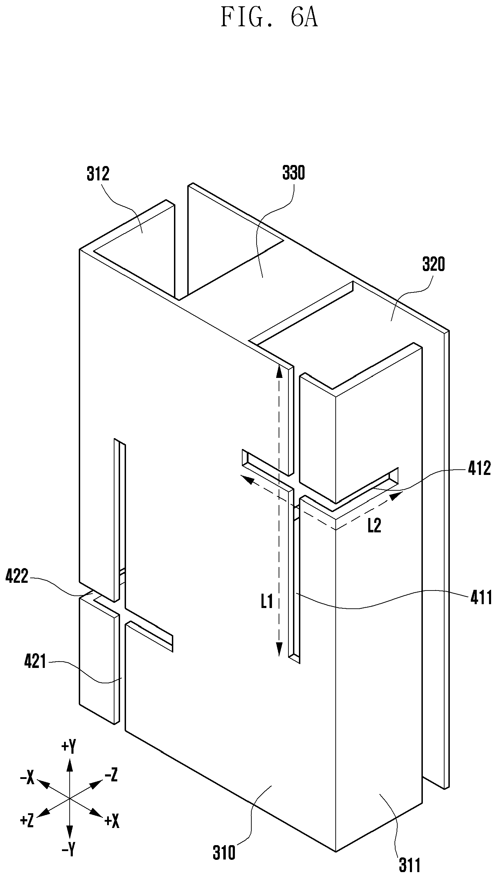

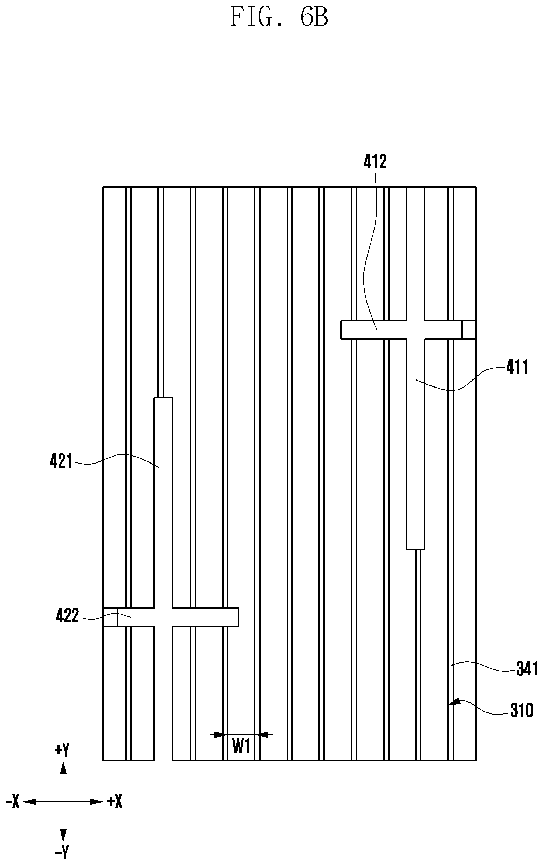

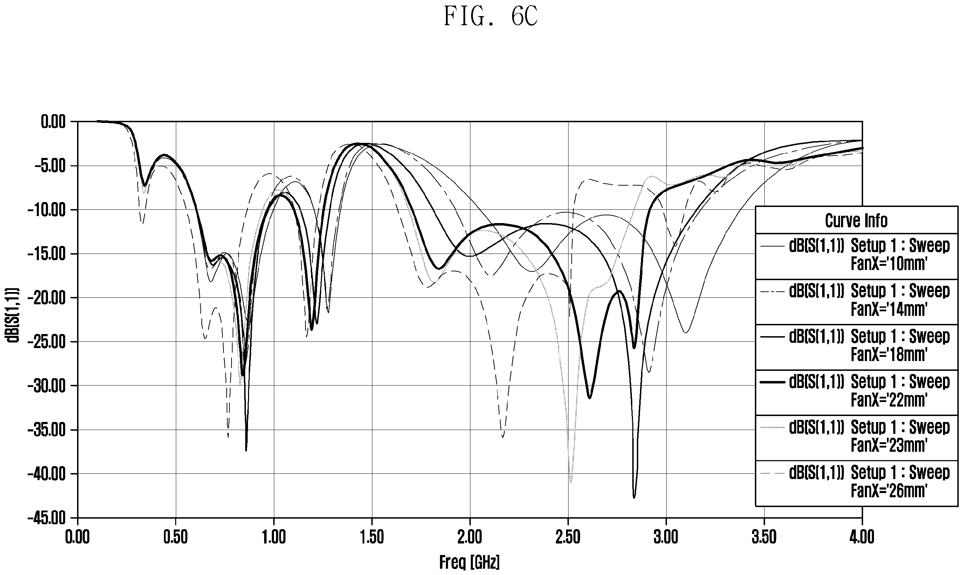

FIG. 6A is a diagram illustrating the first antenna and the second antenna configured on the first heat dissipating plate 310 according to an embodiment of the disclosure. FIG. 6B is a diagram illustrating a structural relation between the first heat dissipating fins 341, and the first opening 411 and the second opening 412 according to an embodiment of the disclosure. FIG. 6C is a diagram illustrating a relation between the first heat dissipating fins 341 and the antenna performance of the first opening 411 and the second opening 412.

According to an embodiment, as illustrated in FIG. 6A, the first opening 411 and the second opening 412 disposed through the first heat dissipating plate 310 may have antenna resonant frequencies determined according to the physical lengths thereof. In an embodiment, the first opening 411 may have a first length L1 by extending the first direction (e.g., the Y-axis direction based on FIG. 6A). The second opening 412 may have a second length L2 by extending the second direction (e.g., the X-axis direction based on FIG. 6A). The first direction and/or the second direction may be oriented in parallel to a surface, e.g. an outer surface, of the first heat dissipating plate 310. The first opening 411 and the second opening 412 may have different lengths, and thus have different antenna resonant frequencies. Therefore, the electronic device 300 may be able to perform communication (e.g., short-range communication or long-range communication) in various frequency bands by using the first heat dissipating plate 310 having different antenna resonant frequencies. One or more of the first opening 411, the second opening 412, the third opening 421, and the fourth opening 422 may each comprise a first portion in a first wall section of the first heat dissipating plate 310, and a second portion in a second wall section of the first heat dissipating plate 310. The first wall section and the second wall section may form an angle with each other, for example, a right angle. In an embodiment, the second opening 412 and the fourth opening may each comprise a first wall section of the first heat dissipating plate 310, and a second portion in a second wall section of the first heat dissipating plate 310.

According to an embodiment, the first antenna may have an antenna resonant frequency changing according to the lengths of the first opening 411 and the second opening 412. In an embodiment, the longer the opening, the smaller the antenna resonant frequency corresponding to the opening. For example, the longer the first length L1 of the first opening 411 and/or the second length L2 of the second opening 412, the smaller the antenna resonant frequency. On the contrary, the shorter the first length L1 of the first opening 411 and/or the second length L2 of the second opening 412, the larger the antenna resonant frequency.

According to an embodiment, a slot antenna may operate as a dipole antenna, and a slit antenna may operate as a monopole antenna. A slot antenna operating as a dipole antenna may have a length equal to half (1/2) of the wavelength of a frequency band required for operation. For example, a slot antenna having a length of about 214.3 mm may be configured on the first heat dissipating plate 310 so as to perform communication in a 700 MHz band. A slit antenna operating as a monopole antenna may have a length equal to one-fourth (1/4) of the wavelength of a frequency band required for operation. For example, a slit antenna may have a length of about 107 mm so as to perform communication in a 700 MHz band. It thus becomes possible to use relatively low frequencies, such as a 700 MHz band, while limiting the dimensions of the first heat dissipating plate 310 which may be a crucial factor when determining the dimensions or size of the electronic device.

According to an embodiment, the higher the frequency, the shorter the wavelength thereof. Therefore, the length of a slot or slit antenna may become shorter. On the contrary, the lower the frequency, the longer the wavelength thereof. Therefore, the length of a slot or slit antenna may become longer. In an embodiment, in order to implement a frequency in a low-band area (e.g., 600 MHz to 1 GHz) which is a relative low frequency area, a longer slit or slot antenna may be required compared to a mid-band area (e.g., 1.7 GHz to 2.1 GHz) and a high-band area (e.g., 2.2 GHz to 2.7 GHz) which is a relative high frequency area. Therefore, the positions of the first opening 411 and the second opening 412 disposed through the first heat dissipating plate 310 may be adjusted according to a necessary frequency band.

In an embodiment, referring to FIG. 6A, a first direction length L1 (e.g., the length in the Y-axis direction based on FIG. 6A) of the first heat dissipating plate 310 may be longer than a second direction length L2 (e.g., the length in the X-axis direction based on FIG. 6A). In this case, the first opening 411 is disposed in the first direction having a relatively longer length on the first heat dissipating plate 310, and may be used for frequency communication in a low-band area. In an embodiment, the first opening 411 may be configured as a slit antenna which has the first length L1 and, one end of which is open. In this case, the first length L1 of the first opening 11 for resonating at a frequency in a low-band area may be reduced compared to when the first opening is a slot antenna.

In an embodiment, referring to FIG. 6A, the second opening 412 used in a mid band and a high band may be disposed in the second direction having a relatively shorter length on the first heat dissipating plate 310. In an embodiment, referring to FIG. 6A, the second opening 412 may be configured as a slot antenna. In an embodiment, the second opening 412 may simultaneously resonate at frequencies in a mid-band area and a high-band area.

The above description is based on the presumption that the first opening 411 is a slit antenna and the second opening 412 is a slot antenna, but the disclosure may not be limited thereto. In an embodiment, each of the first opening 411 and the second opening 412 may be configured as at least one antenna among slit and slot antennas. Hereinafter, for convenience of explanation, as illustrated in FIG. 6A, a description is given under the presumption that the first opening 411 is a slit antenna and the second opening 412 is a slot antenna.

In addition, the above description may also be identically applied to the second antenna including the third opening 421 and the fourth opening 422 as well as the first antenna including the first opening 411 and the second opening 412. For example, a description of the third opening 421 may be replaced with the description of the first opening 411. In addition, a description of the fourth opening 422 may be configured by the description of the second opening 412. In an embodiment, referring to FIG. 6A, the third opening 421 is configured as a slot antenna having the first length L1 on the first heat dissipating plate 310, and may resonate at a low-band frequency. The fourth opening 422 is configured as a slit antenna having the second length L2 on the first heat dissipating plate 310, and may resonate at mid-band and high-band frequencies. The described embodiment allows for a wider radiation pattern and increases the separation distance between the antennas to ensure isolation, while also having the advantage of improved space utilization.

In an embodiment, referring to FIG. 4B, FIG. 4C, and FIG. 6A, the first heat dissipating plate 310 may include a first sectional part 311 and a second sectional part 312. In an embodiment, the first sectional part 311 and the second sectional part 312 may be integrated with the first heat dissipating plate 310, and may be bent from the first heat dissipating plate 310. In an embodiment, the second opening 412 of the first antenna may extend from the first heat dissipating plate 310 to the first sectional part 311.

In an embodiment, referring to FIG. 4B, the fifth opening 430 may be disposed through at least one of the first sectional part 311 and the second sectional part 312. The fifth opening 430 may be an antenna, for example a third antenna, additionally configured on a sectional part so that the electronic device 300 is able to perform communication in multiple bands. In an embodiment, the fifth opening 430 may be configured as a slit antenna, as illustrated in the drawing. In an embodiment not illustrated in the drawings, the fifth opening 430 may be configured as a slot antenna. The electronic device 300 may configure an additional antenna, such as the fifth opening 430, on the first heat dissipating plate 310 according to a necessary frequency for covering multiple bands.

According to an embodiment, as illustrated in FIG. 6B, the first heat dissipating fins 341 may be arranged on the first heat dissipating plate 310 in a direction (e.g., a Z-axis direction based on FIG. 4B) perpendicular to the first direction (e.g., the Y-axis direction based on FIG. 6B) and the second direction (e.g., the X-axis direction based on FIG. 6B). When the first direction is parallel to a base surface, e.g., the largest surface, of the first heat dissipating plate 310, the second direction may orientated be perpendicular to said base surface. The multiple first heat dissipating fins 341 may be spaced apart from each other in the second direction at predetermined gaps (W1 based on FIG. 4B). In addition, the first heat dissipating fins 341 may be spaced a predetermined gap (W2 based on FIG. 4B) apart from each other in the first direction with respect to the second opening 412. For example, the second opening 412 may be disposed between the first heat dissipating fins 341. In this case, a frequency band of the second opening 412 may be tuned by means of the first heat dissipating fins 341. For example, the first heat dissipating fins 341 may affect the movement of current transferred from the feeding part 442 to the second opening 412 perpendicular to the first heat dissipating fins. In this case, the gap, e.g., a size or a length of the gap, of the first heat dissipating fins 341 may adjusted with respect to the second opening 412, to tune a frequency in a mid-band area and a high-band area at which resonance occurs at the second opening 412. In an embodiment, referring to FIG. 6C, frequency tuning in a mid-band area and a high-band area by means of the first heat dissipating fins 341 may be identified. A dashed line graph shown in FIG. 6C represents an input reflection coefficient S11 of the first antenna before tuning using the first heat dissipating fins 341. The input reflection coefficient S11 may be a coefficient for identifying a degree of frequency resonance at the first antenna. For example, as the input reflection coefficient S11 has a low value, loss (reflection) may be low and radiation may be large. A solid line graph shown in FIG. 6C may represent the frequency of the first antenna in a mid-band area and a high-band area for the first heat dissipating fins 341. It may be noted that the frequency in the mid-band area and the high-band area has been tuned by means of the first heat dissipating fins 341, and thus has moved to a relatively high frequency area. Therefore, according to an embodiment of the disclosure, the length (e.g., the length in the Z-axis direction based on FIG. 4B) of the first heat dissipating fins 341 and the transverse gap W1 (e.g., the X-axis direction based on FIG. 6B) of the first heat dissipating fins 341 may be adjusted to tune the frequency of the first antenna in a mid-band area and a high-band area, and the beam pattern and coverage of the antenna may be tuned by means of the first opening 411 and the second opening 412.

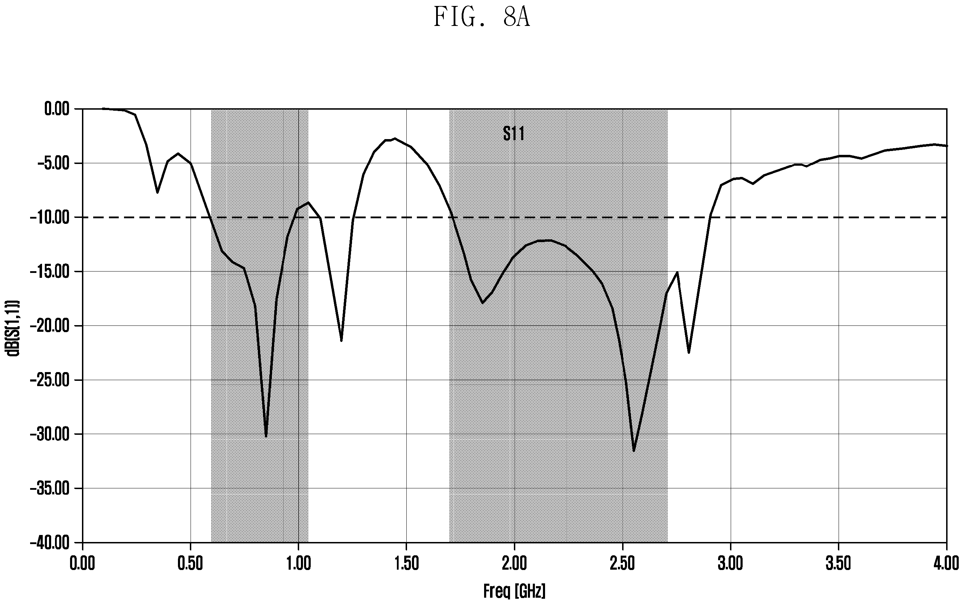

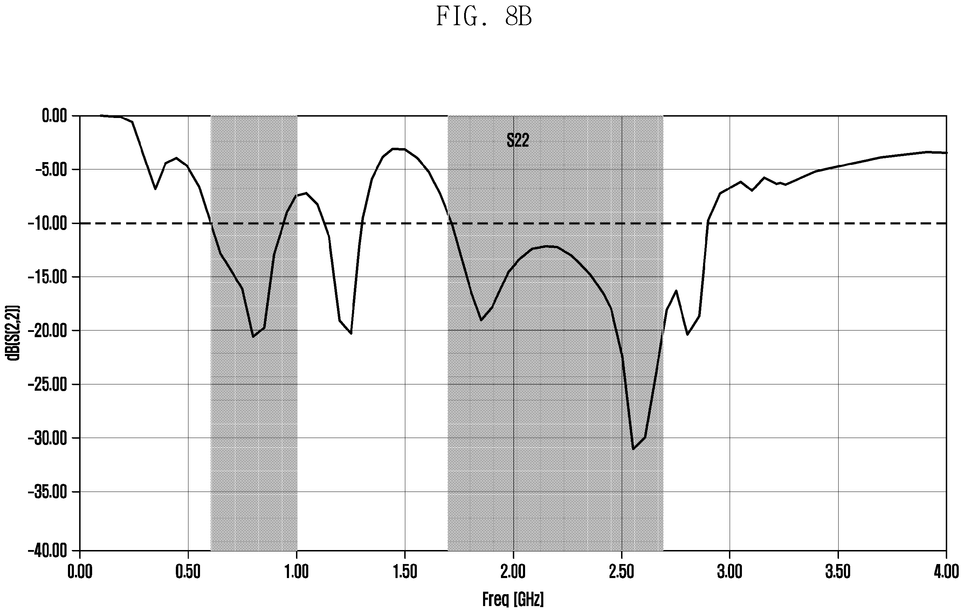

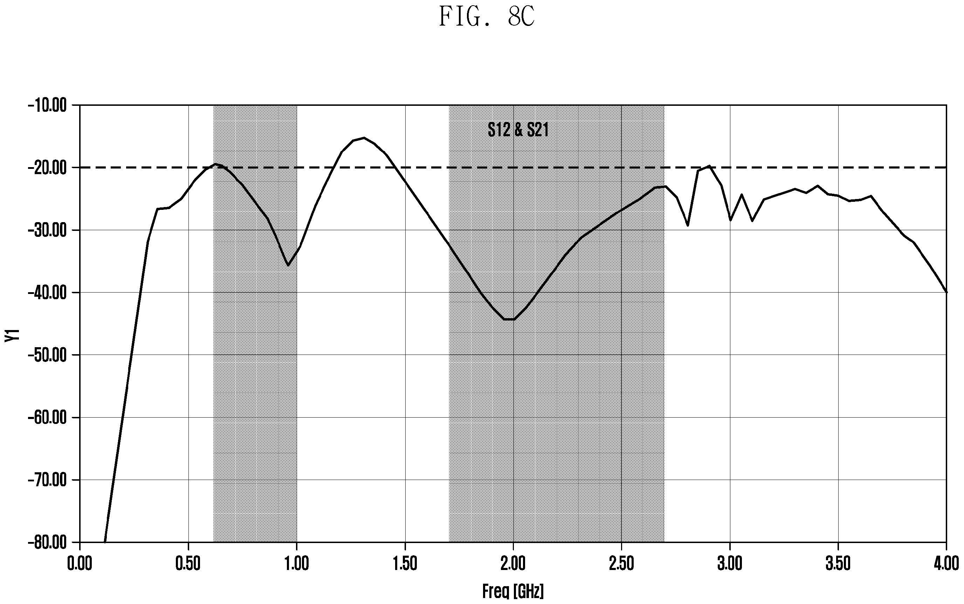

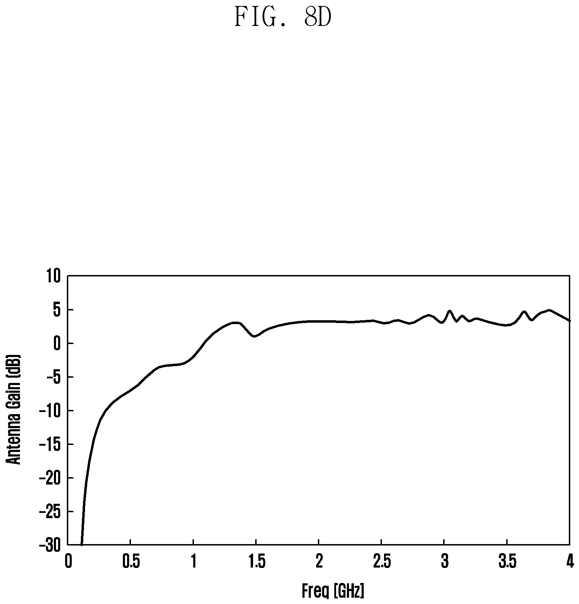

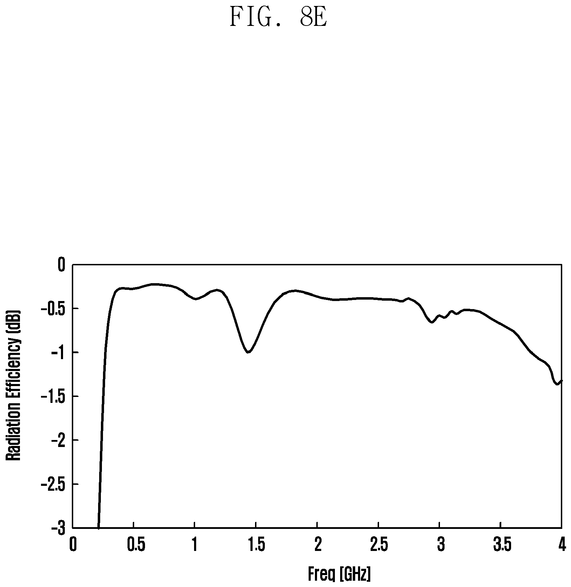

FIG. 7A is a diagram illustrating a relation between the first opening 411 of the first heat dissipating plate 310 and the first feeding part 442a according to an embodiment of the disclosure. FIG. 7B is a diagram illustrating an antenna input reflection coefficient for the first opening 411 according to an embodiment of the disclosure. FIG. 8A is a diagram illustrating an input reflection coefficient of the first antenna of the first heat dissipating plate 310. FIG. 8B is a diagram illustrating an input reflection coefficient of the second antenna of the first heat dissipating plate 310. FIG. 8C is a diagram illustrating isolation between the first antenna and the second antenna of the first heat dissipating plate 310. FIG. 8D is a diagram illustrating the antenna gain of the first antenna and the second antenna of the first heat dissipating plate. FIG. 8E is a diagram illustrating the antenna efficiency of the first antenna and the second antenna of the first heat dissipating plate.

According to an embodiment, as illustrated in FIG. 7A and FIG. 7B, the feeding part 442 may include the first feeding part 442a and the second feeding part 442b. In an embodiment, the first feeding part 442a and the second feeding part 442b may be integrated with each other. The first feeding part 442a may overlap with the first opening 411 by extending in the second direction (e.g., the X-axis direction based on FIG. 7A) perpendicular to the first direction (e.g., the Y-axis direction based on FIG. 7A) that is an extension direction of the first opening 411. In an embodiment, the first feeding part 442a may overlap with the first opening 411 at a central part of the first opening 411. The second feeding part 442b may overlap with the second opening 412 by extending in the first direction perpendicular to the extension direction of the second opening 412. In an embodiment, the second feeding part 442b may overlap with the second opening 412 at a central part of the second opening 412. In an embodiment, the first feeding part 442a and the second feeding part 442b may be integrated with each other and have a shape of ¬-shape or an L-shape to feed power to the first opening 411 and the second opening 412, respectively. In this case, the number of RF ports and a wiring space for the feeding part 442 may be reduced compared to multiple feeding parts 442 being arranged on the first opening 411 and the second opening 412 of the first antenna. However, the shape of the feeding part 442 described above merely corresponds to an example, and a single feeding part 442 having various shapes may simultaneously resonate the first opening 411 and the second opening 412.

In an embodiment, a graph illustrated in FIG. 8A may be a graph showing an input reflection coefficient S11 for the first opening 411 of the first antenna. It may be noted that the first antenna has a low input reflection coefficient S11 in a low-band area (e.g., 500 MHz to 1 GHz) in which the first antenna is resonated through the first opening 411. For example, the first antenna may have a value of about -30 dB (decibel) lower than -10 dB, which is a criterion of the input reflection coefficient S11, in a low-band area of 0.5 GHz to 1 GHz. The input reflection coefficient S11 for the first opening 411 of the first antenna may be lower than -10 dB over the full interval of the low-band area or over more than 80% of the interval of the low-band area, which may be considered the area between, e.g., 0.5 GHz and 1 GHz. In addition, it may be noted that the first antenna has a low input reflection coefficient S11 in a mid-band area (e.g., 1.7 GHz to 2.1 GHz) and a high-band area (e.g., 2.5 GHz to 3.00 GHz) in which the first antenna is resonated through the second opening 412. For example, the first antenna may have a value between about -30 dB and -20 dB lower than -10 dB, which is a criterion value of the input reflection coefficient S 11, in a mid-band area and a high-band area of 2.5 GHz to 3.00 GHz. The input reflection coefficient S11 for the first opening 411 of the first antenna may be lower than -10 dB over the full interval of the mid-band area or over more than 80% of the interval of the mid-band area, which may be considered the area between, e.g., 1.7 GHz and 2.1 GHz. The input reflection coefficient S11 for the first opening 411 of the first antenna may be lower than -10 dB over the full interval of the high-band area or over more than 80% of the interval of the high-band area, which may be considered the area between, e.g., 2.5 GHz and 3.00 GHz. Therefore, radiation of a communication signal by the first antenna may be smoothly performed in the low-band area, the mid-band area, and the high-band area. The criterion value of the input reflection coefficient S 11 described above may be changed according to the type of the electronic device 300 and the size of the antenna.

In an embodiment, the second antenna may resonate at a frequency in a band substantially the same as that of the first antenna. Referring to FIG. 8B, an input reflection coefficient S22 of the second antenna may be identified. The input reflection coefficient S22 may be a coefficient for identifying a degree of frequency resonance at the second antenna. For example, as the input reflection coefficient S22 has a low value, loss (reflection) may be low. Therefore, a value of radiation from the second antenna may be large. The third opening 421 of the second antenna may resonate at a low-band frequency similarly to the first opening 411. The fourth opening 422 of the second antenna may resonate at mid-band and high-band frequencies similarly to the second opening 412. Therefore, the second antenna may have a value of about -20 dB lower than -10 dB, which is a criterion value of the input reflection coefficient S22, in a low-band area of 0.5 GHz to 1 GHz due to the third opening 421 being resonated in the low-band area. The input reflection coefficient S22 for the second antenna may be lower than -10 dB over the full interval of the low-band area or over more than 80% of the interval of the low-band area, which may be considered the area between, e.g., 0.5 GHz and 1 GHz. For example, the second antenna may have a value between about -30 dB and -20 dB lower than -10 dB, which is a criterion value of the input reflection coefficient S22, in a mid-band area and a high-band area of 2.5 GHz to 3.00 GHz due to the fourth opening 422 being resonated in the mid-band area and the high-band area. The input reflection coefficient S22 for the second antenna may be lower than -10 dB over the full interval of the mid-band area or over more than 80% of the interval of the mid-band area, which may be considered the area between, e.g., 1.7 GHz and 2.1 GHz. The input reflection coefficient S22 for the second antenna may be lower than -10 dB over the full interval of the high-band area or over more than 80% of the interval of the high-band area, which may be considered the area between, e.g., 2.5 GHz and 3.00 GHz.

In an embodiment, the first antenna and the second antenna may be spaced a predetermined gap from each other to ensure antenna performance when the first antenna and the second antenna resonate at a frequency in substantially the same band. In an embodiment, as illustrated in FIG. 6A described above, the first antenna and the second antenna may be spaced a predetermined gap from each other. In this case, the first antenna and the second antenna may secure the isolation therebetween, and thus do not affect mutual antenna performance. In an embodiment, referring to FIG. 8C, an input reflection coefficient S21 and an input reflection coefficient S12 may be identified. The input reflection coefficient S21 may be a coefficient indicating a degree at which a signal of the first antenna interferes with a signal of the second antenna. The input reflection coefficient S12 is a coefficient indicating a degree at which a signal of the second antenna interferes with a signal of the first antenna. The smaller the values of the input reflection coefficient S12 and the input reflection coefficient S21, the smaller the interference between the two antennas may be. The first antenna and the second antenna of the disclosure may have a value of about -35 dB lower than -20 dB, which is a criterion value of the input reflection coefficients S12 and S21, in a low-band area in which resonance occurs at the first opening 411 of the first antenna and the third opening 421 of the second antenna. The input reflection coefficient S12 and/or the input reflection coefficient S21 may be lower than -20 dB over the full interval of the low-band area or over more than 80% of the interval of the low-band area, which may be considered the area between, e.g., 0.5 GHz and 1 GHz. In addition, the first antenna and the second antenna may have a value of about - 40 dB lower than -20 dB, which is a criterion value of the input reflection coefficients S12 and S21, in a mid-band area and a high-band area in which resonance occurs at the second opening 412 of the first antenna and the fourth opening 422 of the second antenna. The input reflection coefficient S12 and/or the input reflection coefficient S21 may be lower than -20 dB over the full interval of the mid-band area or over more than 80% of the interval of the mid-band area, which may be considered the area between, e.g., 1.7 GHz and 2.1 GHz. The input reflection coefficient S12 and/or the input reflection coefficient S21 may be lower than -20 dB over the full interval of the high-band area or over more than 80% of the interval of the high-band area, which may be considered the area between, e.g., 2.5 GHz and 3.00 GHz. Therefore, the first antenna and the second antenna are spaced a predetermined gap from each other and secure isolation therebetween, so that signal interference between the two antennas may be reduced.

The first antenna and the second antenna substantially resonate at a frequency in substantially the same band, and thus the beam pattern and coverage of the antennas may be widened through the first heat dissipating plate 310. Therefore, the antenna performance of the electronic device 300 using the first heat dissipating plate 310 may be improved.

In an embodiment, the connection part 330 may be disposed between the first heat dissipating plate 310 and the second heat dissipating plate 320. In an embodiment, the connection part 330 may be disposed between the first antenna (e.g., the first opening 411 and the second opening 412) and the second antenna (e.g., the third opening 421 and the fourth opening 422). In this case, a part of current having been transferred to the first antenna through the feeding part 442 is induced to the connection part 330, and thus current of the first antenna induced to the second antenna may be reduced. In addition, a part of current having been transferred to the second antenna through the feeding part 442 is induced to the connection part 330, and thus current of the second antenna induced to the first antenna may be reduced. Therefore, signal interference between the first antenna and the second antenna may be small.

According to an embodiment of the disclosure, the first antenna and the second antenna may be configured on the first heat dissipating plate 310. The first antenna is a slit or slot antenna, and includes the first opening 411 and the second opening 412 being orthogonal. In addition, the second antenna is a slit or slot antenna, and includes the third opening 421 and the fourth opening 422 being orthogonal. The first antenna may be resonated at a frequency in various bands through the first opening 411 and the second opening 412 having different lengths. Similarly, the second antenna may be resonated at a frequency in various bands through the third opening 421 and the fourth opening 422 having different lengths. The first antenna and the second antenna may be resonated in substantially the same frequency band. The first antenna and the second antenna may be spaced a predetermined gap from each other so as to prevent interference between mutual antenna signals. In an embodiment, referring to FIG. 8D and FIG. 8E, antenna gain and antenna efficiency for the first heat dissipating plate 310 of the disclosure may be identified. The first heat dissipating plate 310 may have a high antenna gain and a high antenna efficiency in a low-band area (e.g., 600 MHz to 1 GHz), a mid-band area (e.g., 1.7 GHz to 2.1 GHz), and a high-band area (e.g., 2.2 GHz to 2.7 GHz) in which the first antenna and the second antenna resonate. Therefore, the electronic device 300 of the disclosure may secure a predetermined level of antenna performance by means of the first heat dissipating plate 310 while dissipating heat of an electronic component used for communication through the first heat dissipating plate 310.

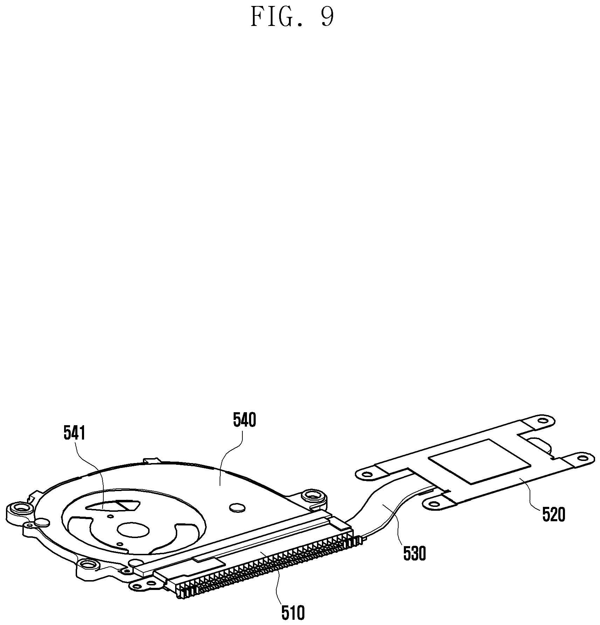

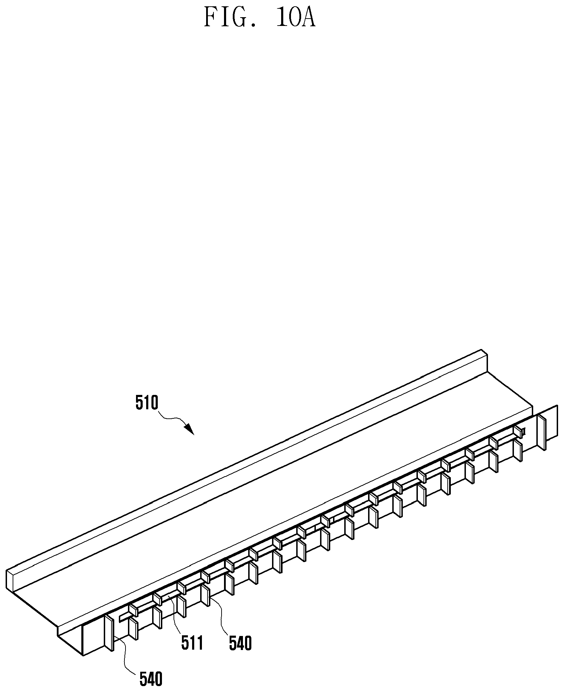

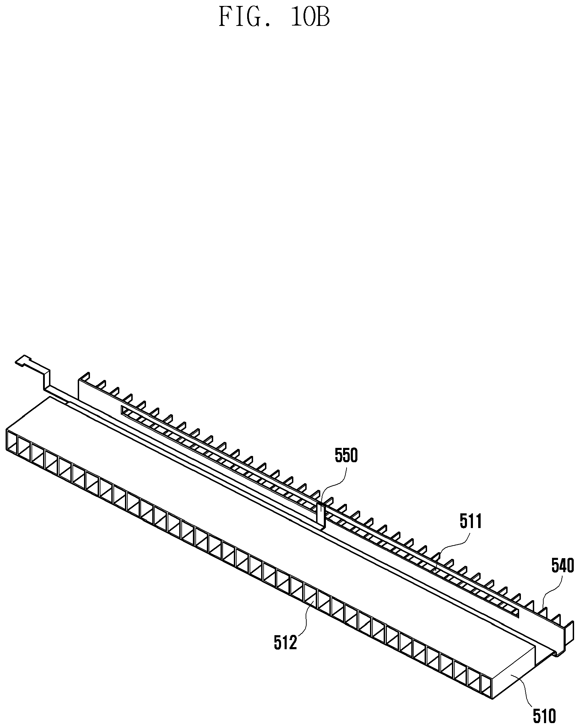

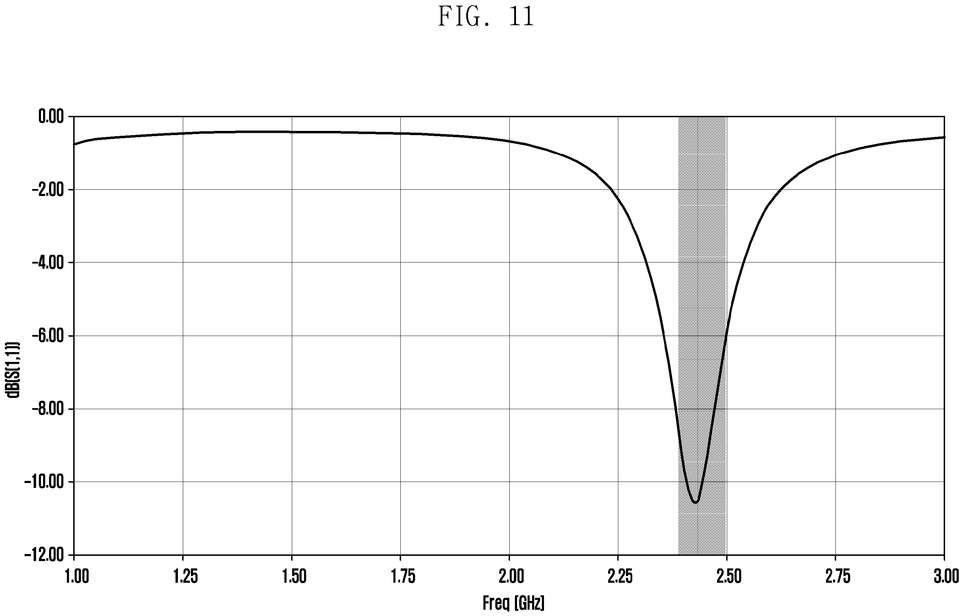

FIG. 9 is a diagram of a heat sink according to an embodiment. FIG. 10A and FIG. 10B are diagrams of a first heat dissipating plate 510 of the heat sink illustrated in FIG. 9. FIG. 11 is a diagram illustrating an antenna input reflection coefficient for a first opening 511 disposed through the first heat dissipating plate 510 of FIG. 9.

In an embodiment, the heat sink to be described with reference to FIG. 9 to FIG. 11 may be used in the electronic device illustrated in FIG. 3A and FIG. 3B. In addition, the heat sink to be described with reference to FIG. 9 to FIG. 11 may be used in a different electronic device (e.g., notebook PC). In the following description, a description of elements identical or similar to the elements described above will be omitted.

According to an embodiment, as illustrated in FIG. 9, a heat sink of an electronic device may include a heat dissipating device 501 for discharging heat generated by an electronic component, to the outside of the electronic device, the first heat dissipating plate 510 made of a metallic material, a second heat dissipating plate 520 in contact with the electronic component, and a heat pipe 530 connecting the first heat dissipating plate 510 and a second heat dissipating plate 520. In an embodiment, the heat dissipating device 501 may include a fan 502 causing air circulation and a ventilation port (not illustrated) connected to a space where the fan 502 is positioned. The heat dissipating device 501 may be configured such that the ventilation port is adjacent to a vent hole 512 disposed through a heat dissipating plate. In an embodiment, the inside and outside of the electronic device may be connected through the vent hole 512. The heat dissipating device 501 may generate a pressure difference according to rotation of the fan 502. In an embodiment, a pressure difference between the inside and outside of the electronic device occurs due to rotation of the fan 502, and heat with high temperature generated in the inside of the electronic device may be discharged to the outside of the electronic device through the vent hole 512. For example, heat having been transferred from the electronic component to the second heat dissipating plate 520 may be transferred to the first heat dissipating plate 510 through the heat pipe 530. Heat having been transferred to the first heat dissipating plate 510 may be discharged to the outside of the electronic device through air flow of the heat dissipating device 501.

According to an embodiment, as illustrated in FIG. 10A and FIG. 10B, the first heat dissipating plate 510 may be electrically connected to the communication module 190 and be used as an antenna that receives or transmits radio waves. In an embodiment, the first opening 511 for operation as a slit and/or slot antenna may be disposed through the first heat dissipating plate 510 or traverse the first heat dissipating plate 310. In an embodiment, the first opening 511 may extend in a direction parallel to an extension direction of the vent hole 512, and may be disposed through or traverse the first heat dissipating plate 510 in a shape of a slot. In an embodiment, referring to FIG. 11 described later, the first heat dissipating plate 510 may transmit or receive a communication signal at a frequency in an about 2.4 GHz band through the first opening 511.

In an embodiment, referring to FIG. 10B, the first heat dissipating plate 510 may transmit or receive a communication signal in a particular frequency band with an external electronic device through a feeding part 550 made of a conductive material. In an embodiment, the feeding part 550 may be a micro strip. In addition, the feeding part 550 may be implemented to have an impedance of 50 Ohm. In an embodiment, the feeding part 550 may at least partially overlap with the first opening 511. For example, the feeding part 550 may cross over a central part of the first opening 511. The first opening 511 may be resonated at a frequency in a particular band by means of the first feeding part 550.

The above description is, for convenience of explanation, based on the presumption that only the first opening 511 is disposed through the first heat dissipating plate 510, but the disclosure may not be limited thereto. In an embodiment not illustrated in the drawing, the first opening 511 may be configured to have a shape of a slit which extends in a direction parallel to an extension direction of the vent hole 512, and one end of which is open. In addition, in an embodiment, the first heat dissipating plate 510 may include a second opening that is perpendicular to the extension direction of the vent hole 512 and is connected to the first opening 511. In an embodiment, the first opening 511 and the second opening may be connected orthogonally. In an embodiment, the first opening 511 and the second opening may have different lengths. In this case, the first opening 511 and the second opening may be resonated at frequencies in different bands by means of the feeding part 550.

According to an embodiment, as illustrated in FIG. 11, the first heat dissipating plate 510 may transmit or receive a communication signal at a frequency in an about 2.4 GHz band through the first opening 511. In an embodiment, it may be noted that the first heat dissipating plate 510 has a low input reflection coefficient S11 at about 2.4 GHz. In this case, the first heat dissipating plate 510 may have a radiation degree larger than a loss degree of a communication signal in an about 2.4 GHz band. Therefore, the electronic device of the disclosure may secure a predetermined level of antenna performance by means of the first heat dissipating plate 510 and simultaneously a predetermined level of performance of dissipating heat from an electronic component.

According to an embodiment, as illustrated in FIG. 10A and FIG. 10B, heat dissipating fins 540 may be arranged on the first heat dissipating plate 510 in a direction parallel to the extension direction of the vent hole 512. In an embodiment, the first opening 511 may be disposed between the heat dissipating fins 540. In this case, a frequency band of the first opening 511 may be tuned by means of the heat dissipating fins 540. For example, the heat dissipating fins 540 may affect the current movement of the first opening 511 perpendicular to the heat dissipating fins so as to tune a frequency band in which resonance occurs at the first opening 511.

Embodiments of the present invention provide an antenna structure that utilises a single L-shaped feed and cross slot structure, and is capable of adjusting bandwidth and gain through a heat dissipating fin, as well as functioning as an antenna with a heat sink itself, which has the effect of increasing heat dissipation performance to the maximum in a limited volume while simultaneously reducing antenna performance degradation. This can be applied to various wireless communication devices, and examples include notebook PCs, CPEs, and wireless routers.

An electronic device 300 (e.g., the electronic device 101 in FIG. 1) according to an embodiment of the disclosure may include a communication module 190, a first heat dissipating plate 310 that is made of a metallic material and includes a first antenna including a first opening 411 extending in a first direction (e.g., the Y-axis direction based on FIG. 6A) and a second opening 412 extending in a second direction (e.g., the X-axis direction based on FIG. 6A) and connected to the first opening, a first printed circuit board 440 disposed on the first heat dissipating plate and including a feeding part 442 that overlaps with at least a part of the first opening and the second opening, is made of a metallic material, and is electrically connected to the communication module 190 of the electronic device, and a heat dissipating fin 341 (e.g., the first heat dissipating fin 341 in FIG. 4A) made of a metallic material and disposed on the first heat dissipating plate in a direction perpendicular to the first direction and the second direction.

In addition, the electronic device may include a second heat dissipating plate 320 made of a metallic material and a second printed circuit board 450 disposed on the second heat dissipating plate and including the communication module electrically connected to the feeding part.

In addition, the first opening and the second opening of the first antenna may transmit or receive frequencies in different bands, respectively.

In addition, the first opening of the first antenna may extend by a first length L1 in the first direction, and the second opening of the first antenna may extend by a second length L2 in the second direction.

In addition, the first opening and the second opening of the first antenna may be orthogonal to each other.

In addition, the first heat dissipating plate may be disposed to face the second heat dissipating plate, and the electronic device may include a connection part 330 that is made of a metallic material and is in contact with the first heat dissipating plate and the second heat dissipating plate.

In addition, the electronic device may further include an RF connection member 460 electrically connecting the feeding part of the first printed circuit board and the communication module of the second printed circuit board.

In addition, the first heat dissipating plate may include a second antenna including a third opening 421 extending in the first direction and a fourth opening 422 extending in the second direction and connected to the third opening.

In addition, the first antenna and the second antenna may transmit or receive a frequency in an identical band.

In addition, the electronic device may include a sectional part 311 or 312 integrated with the first heat dissipating plate and bent from the first heat dissipating plate, and the second opening may extend from one surface of the first heat dissipating plate to the sectional part.

In addition, the electronic device may further include a fifth opening 430 disposed through the sectional part.

In addition, the first printed circuit board may include a ground part (ground) 441 which is made of a conductive material, and at least a part of which is in contact with the first heat dissipating plate.

In addition, at least one of the first opening and the second opening may have a shape of a slit, one end of which is open.

In addition, the feeding part may include a first feeding part 442a extending in the second direction and overlapping with the first opening and a second feeding part 442b extending in the first direction and overlapping with the second opening.

In addition, the first feeding part may cross over a center of the first opening, and the second feeding part may cross over a center of the second opening.

A heat sink disposed in an electronic device including a communication module 190 to transmit or receive a communication signal with an external electronic device may include a heat dissipating plate 510 that includes a first opening 511 extending in a first direction and is made of a metallic material, a first printed circuit board 440 disposed on the heat dissipating plate and including a feeding part 550 that overlaps with at least a part of the first opening, is made of a metallic material, and is electrically connected to the communication module 190 of the electronic device, and a heat dissipating fin 540 disposed on the heat dissipating plate and made of a metallic material.

In addition, the heat dissipating plate may include a second opening that extends in a second direction perpendicular to the first direction and is connected to the first opening, and the feeding part may overlap with at least a part of the second opening.

In addition, the first opening may extend by a first length in the first direction, the second opening may extend by a second length in the second direction, and the first opening and the second opening may transmit or receive frequencies in different bands, respectively.

In addition, the heat sink may further include a heat dissipating device 501 including a fan 502 configured to cause air circulation and a ventilation port connected to a space where the fan is positioned, and the heat dissipating plate may include a vent hole 512 connected to the ventilation port of the heat dissipating device.

In addition, at least one of the first opening and the second opening may have a shape of a slit, one end of which is open.

## Claims

1. An electronic device (101, 300) comprising:
a communication module (190);
a first heat dissipating plate (310) that is made of a metallic material and comprises a first antenna including a first opening (411) extending in a first direction and a second opening (412) extending in a second direction and connected to the first opening;
a first printed circuit board (440) disposed on the first heat dissipating plate (310) and comprising a feeding part (442) that overlaps with at least a part of the first opening and the second opening (412), the feeding part (442) being made of a metallic material, and is electrically connected to the communication module (190); and
a heat dissipating fin (341) made of a metallic material and disposed on the first heat dissipating plate in a direction perpendicular to the first direction and the second direction.

2. The electronic device (101, 300) of claim 1, further comprising:
a second heat dissipating plate (320) made of a metallic material; and
a second printed circuit board (450) disposed on the second heat dissipating plate (320) and comprising the communication module (190) electrically connected to the feeding part (442).

3. The electronic device (101, 300) of claim 1, wherein the first opening and the second opening of the first antenna are configured to transmit or receive frequencies in different bands, respectively.

4. The electronic device (101, 300) of claim 1, wherein the first opening of the first antenna extends by a first length (L1) in the first direction, and
wherein the second opening of the first antenna extends by a second length (L2) in the second direction.

5. The electronic device (101, 300) of claim 2, wherein the first heat dissipating plate (310) is disposed to face the second heat dissipating plate (320), and
wherein the electronic device (101, 300) comprises a connection part (330) that is made of a metallic material and is in contact with the first heat dissipating plate (310) and the second heat dissipating plate (320).

6. The electronic device (101, 300) of claim 2 or claim 5, further comprising an RF connection member (460) electrically connecting the feeding part (442) of the first printed circuit board (440) and the communication module (190) of the second printed circuit board.

7. The electronic device (101, 300) of one of claims 1 through 6, wherein the first heat dissipating plate (310) comprises a second antenna including a third opening (421) extending in the first direction and a fourth opening (422) extending in the second direction and connected to the third opening (421).

8. The electronic device (101, 300) of one of claims 1 through 7, further comprising a sectional part (311, 312) integrated with the first heat dissipating plate (310) and bent from the first heat dissipating plate (310),
wherein the second opening (412) extends from one surface of the first heat dissipating plate (310) to the sectional part (311, 312).

9. The electronic device (101, 300) of claim 8, further comprising a fifth opening (430) disposed through the sectional part (311, 312).

10. The electronic device (101, 300) of one of claims 1 through 9, wherein the first printed circuit board (440) comprises a ground part (ground) (441) which is made of a conductive material, and at least a part of which is in contact with the first heat dissipating plate (310).

11. The electronic device (101, 300) of claim 1, wherein at least one of the first opening (411) and the second opening(412) has a shape of a slit, one end of which is open.

12. The electronic device (101, 300) of one of claims 1 through 11, wherein the first opening (411) and the second (412) opening of the first antenna are orthogonal to each other, and wherein the feeding part (442) comprises a first feeding part (442a) extending in the second direction and overlapping with the first opening (411) and a second feeding part (442b) extending in the first direction and overlapping with the second opening (412).

13. The electronic device (101, 300) of claim 12, wherein the first feeding part (422a) crosses over a center of the first opening (411), and
wherein the second feeding part (422b) crosses over a center of the second opening (412).

14. A heat sink disposed in an electronic device including a communication module (190) to transmit or receive a communication signal with an external electronic device, the heat sink comprising:
a heat dissipating plate (510) that comprises a first opening (511) extending in a first direction and is made of a metallic material;
a first printed circuit board (440) disposed on the heat dissipating plate (510) and comprising a feeding part (550) that overlaps with at least a part of the first opening (511), the feeding part (550) being made of a metallic material, and is electrically connected to the communication module (190) of the electronic device; and
a heat dissipating fin (540) disposed on the heat dissipating plate (510) and made of a metallic material.

15. The heat sink of claim 14, wherein the heat dissipating plate (510) comprises a second opening that extends in a second direction perpendicular to the first direction and is connected to the first opening (511),
wherein the feeding part (550) overlaps with at least a part of the second opening,
wherein the first opening (511) extends by a first length in the first direction,
wherein the second opening extends by a second length in the second direction, and
wherein the first opening (511) and the second opening are configured to transmit or receive frequencies in different bands, respectively.
